# FASCICULE DE BREVET EUROPEEN

(11) **EP 1 597 606 B1**
(45) Date de publication et mention de la délivrance du brevet: **29.05.2013**
(21) Numéro de dépôt: 04712593.5
(22) Date de dépôt: 19.02.2004
(51) Int. Cl.: G01R 33/05

(54) **CAPTEUR MINIATURE DE CHAMP MAGNETIQUE**
MINIATURMAGNETFELDSENSOR
MINIATURE MAGNETIC FIELD SENSOR

(30) Priorité: 24.02.2003 FR 0302238
(43) Date de publication de la demande: 23.11.2005
(73) Titulaire: Commissariat à l'Énergie Atomique et aux Énergies Alternatives, 75015 Paris (FR)
(72) Inventeur: JOISTEN, Hélène, F-38000 Grenoble (FR); CUCHET, Robert, F-38930 Monestier de Percy (FR)
(74) Mandataire: Colombo, Michel
(86) Numéro de dépôt international: PCT/FR2004/000389
(87) Numéro de publication internationale: WO 2004/077074

(56) Documents cités:
- WO-A-92/01945
- FR-A- 2 802 650
- US-A- 4 891 725
- DEAK J ET AL: "A LOW-NOISE SINGLE-DOMAIN FLUXGATE SENSOR" APPLIED PHYSICS LETTERS, AMERICAN INSTITUTE OF PHYSICS. NEW YORK, US, vol. 69, no. 8, 19 août 1996 (1996-08-19), pages 1157-1159, XP000626150 ISSN: 0003-6951

## Description

L'invention concerne les capteurs miniatures de champ magnétique.

Un tel produit est parfois désigné par l'expression de "capteur micro-fluxgate".

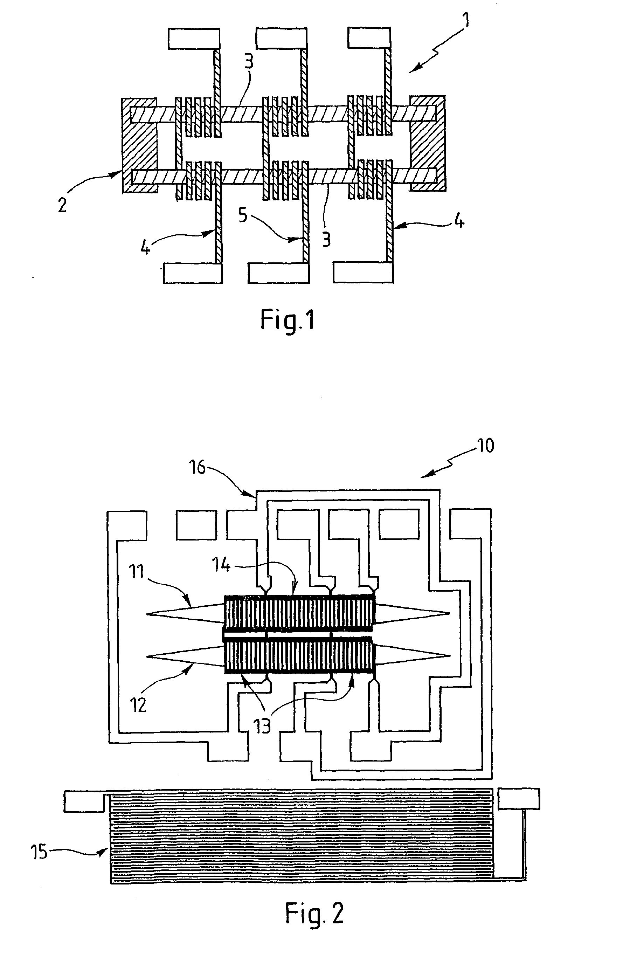

La figure 1 est un schéma de principe d'un tel capteur 1, avec un circuit magnétique fermé 2, sur les branches allongées 3 duquel sont enroulés des bobinages d'excitation 4 et un bobinage de détection 5.

Le capteur est réalisé selon les techniques classiques de microtechnologie. C'est ainsi que le circuit magnétique est en un matériau magnétique doux déposé en couches minces (notamment : Permalloy ®, matériau amorphe ou autre...). Quant aux bobinages d'excitation et de détection, ils sont réalisés en couches minces à l'aide d'un matériau conducteur tel que l'aluminium, le cuivre, l'or... Ces bobinages peuvent être solénoïdaux, ou en spirale planaire, notamment.

Le circuit de détection recueille le flux magnétique provenant du matériau magnétique doux excité par le courant circulant dans le(s) circuit(s) d'excitation.

Les bobinages peuvent être entrelacés.

Il peut exister un bobinage supplémentaire pour appliquer un champ compensant le champ magnétique continu ou Basse Fréquence à mesurer. Mais le bobinage de détection peut aussi être utilisé à cet effet.

En pratique, le signal nécessite une zone de saturation du matériau magnétique et, dans le cas où la saturation est atteinte, au moins en partie, le flux magnétique recueilli par le bobinage de détection n'a plus les mêmes alternances en présence du champ continu à mesurer. Or le signal de détection est la dérivée de ce flux.

Cette dissymétrie se traduit par l'apparition d'une harmonique d'ordre 2 dans le signal de détection, liée au champ continu à mesurer.

Pour augmenter le signal mesuré, on peut prévoir deux circuits de détection montés en différentiel, auquel cas, le signal de détection a une fréquence double du signal d'excitation.

Les capteurs miniatures appelés "microfluxgates" sont des capteurs typiquement destinés à mesurer des champs magnétiques continus ou de basse fréquence (ou des variations de champ magnétique), de l'ordre de quelques nanoteslas actuellement, et dans une gamme d'environ +/- 100 microteslas. Ils sont notamment utilisés pour détecter de très faibles variations du champ magnétique terrestre.

Le fait que les microfluxgates soient de petite taille a pour avantage d'apporter une grande légèreté, peu d'encombrement (ce qui est intéressant dans les applications spatiales, médicales, dans différentes applications industrielles, dans des pinces ampèremétriques...) et un faible coût de fabrication compte tenu de la mise en oeuvre des techniques de fabrication collective, par la technologie de la micro-électronique magnétique.

Des exemples de composants intégrés de type microfluxgates sont notamment décrits dans les documents suivants :
- "High directional sensitivity of micromachined magnetic fluxgate sensors" de RAHMAN A. RUB, SUKIRTI GUPTA, and CHONG H. AHN - University of Cincinnati, Ohio, 45221 - 0030 - USA, Transducers '01 EUROSENSORS XV - 2001,
- "Performance and applications of a two axes fluxgate magnetic field sensor fabricated by a CMOS process" de H. GRÜGER, R. GOTTFRIED-GOTTFRIED - Fraunhofer Institute for microelectronic circuits and systems IMS Dresden, Germany - Sensor and Actuators A 91 (2001) 61-64,
- "Micro fluxgate magnetic sensor interface circuits using deltaS Modulation" Shuji KOGA, Akira YAMASAWA, Shoji KAWAHITO-Toyohashi Univ of Technology - T IEE Japan, vol 117-E, n°2, (1997)
- "A miniaturized magnetic-field sensor system consisting of a planar fluxgate sensor and a CMOS readout circuitry" de R. GOTTFRIED-GOTTFRIED, W. BUDDE, R. JÄHNE, H. KÜCK - Fraunhofer Institute for microelectronic circuits and systems IMS Dresden, Germany - Sensor and Actuators A54 (1996) 443-447.

Les circuits qui y sont décrits sont soit fermés (en boucle), soit ouverts avec des barreaux parallélépipédiques.

Mais des problèmes d'instabilité ou de décalages (on parle parfois de "sauts d'offset") empêchent en pratique de descendre vers la détection de très faibles champs magnétiques. Le signal temporel de mesure pourrait théoriquement présenter un bruit de l'ordre du nanoTesla, mais est en pratique très dégradé par la présence d'instabilités ou de sauts, pouvant être de l'ordre de 100 à 1000 nanoTeslas. Ces sauts se produisent à quelques Hz, mais aussi à une fréquence de l'ordre de toutes les secondes, toutes les minutes, toutes les heures, voire à une fréquence quotidienne.

L'invention a pour objet un capteur de champ magnétique, dont la configuration, pouvant être mise en oeuvre par les techniques de microtechnologie, permette une mesure de faibles champs, tels les champs magnétiques terrestres, tout en minimisant les instabilités ou les sauts.

Elle propose à cet effet un capteur miniature de champ magnétique comportant un noyau magnétique coopérant avec au moins un bobinage d'excitation et un bobinage de détection, caractérisé en ce noyau est ouvert et comporte au moins un barreau ayant des extrémités effilées.

Selon des dispositions préférées, éventuellement combinées :
- le noyau comporte au moins un second barreau ayant des extrémités effilées,
- le noyau est formé de deux barreaux symétriques l'un de l'autre vis-à-vis d'une ligne les séparant,
- les extrémités d'au moins ce barreau sont symétriques l'une de l'autre,
- l'une au moins des extrémités de ce barreau est symétrique par rapport à une ligne médiane longitudinale de ce barreau,
- l'une au moins des extrémités de ce barreau est dissymétrique par rapport à une ligne médiane longitudinale de ce barreau,
- l'une au moins des extrémités est délimitée par des bords rectilignes qui convergent l'un vers l'autre,
- l'une au moins des extrémités se termine par une pointe aiguë,
- cette pointe forme un angle inférieur à 45°, de préférence inférieur à 30°,
- l'une au moins des extrémités se termine par une pointe arrondie
- l'une au moins des extrémités a une longueur supérieure à la largeur du barreau,
-
-
-
- ce capteur comporte deux bobinages d'excitation disposés de part et d'autre d'un bobinage de détection,
- ce capteur est formé d'un empilement de couches.

Des objets, caractéristiques et avantages de l'invention ressortent de la description qui suit, donnée à titre d'exemple illustratif non limitatif, en regard des dessins annexés sur lesquels :
- la figure 1 est un schéma d'un capteur de champ magnétique classique,
- la figure 2 est un schéma d'un capteur de champ magnétique selon l'invention,
- les figures 3A à 3D sont des représentations schématiques de barreaux pouvant être intégrés au capteur de la figure 2,
- les figures 4A à 4D sont des schémas représentant quatre étapes successives de la fabrication d'un capteur selon l'invention, et
- la figure 5 est un diagramme corrélant, pour un capteur conforme à l'invention, le bruit (en dBV / √Hz) et le signal (en dBV) au numéro de puce analysée dans un lot.

La figure 2 représente un capteur conforme à l'invention.

Ce capteur désigné sous la référence générale 10 comporte notamment un noyau magnétique ouvert, ici formé de deux barreaux parallèles 11 et 12 en matériau magnétique, coopérant avec des bobinages d'excitation 13 et des bobinages de détection 14, et des pistes métalliques 15 connectées à ces bobinages. Ce circuit comporte des pistes 16 en contact avec certaines des spires des bobinages, délimitant ainsi les bobinages 13 et 14.

Selon l'invention, les barreaux parallèles 11 et 12 ont des extrémités effilées ou en pointe. Dans le contexte de l'invention, une extrémité effilée ou en pointe est une extrémité de largeur non pas constante, mais décroissante jusqu'à une extrémité étroite, aiguë ou arrondie. Sur la figure 2, les extrémités effilées des deux barreaux sont en saillie vis-à-vis des bobinages. Toutefois, en variante non représentée, elles peuvent se situer en tout ou partie à l'intérieur des bobinages.

L'angle de la pointe est avantageusement aigu (c'est à dire inférieur à 90°).

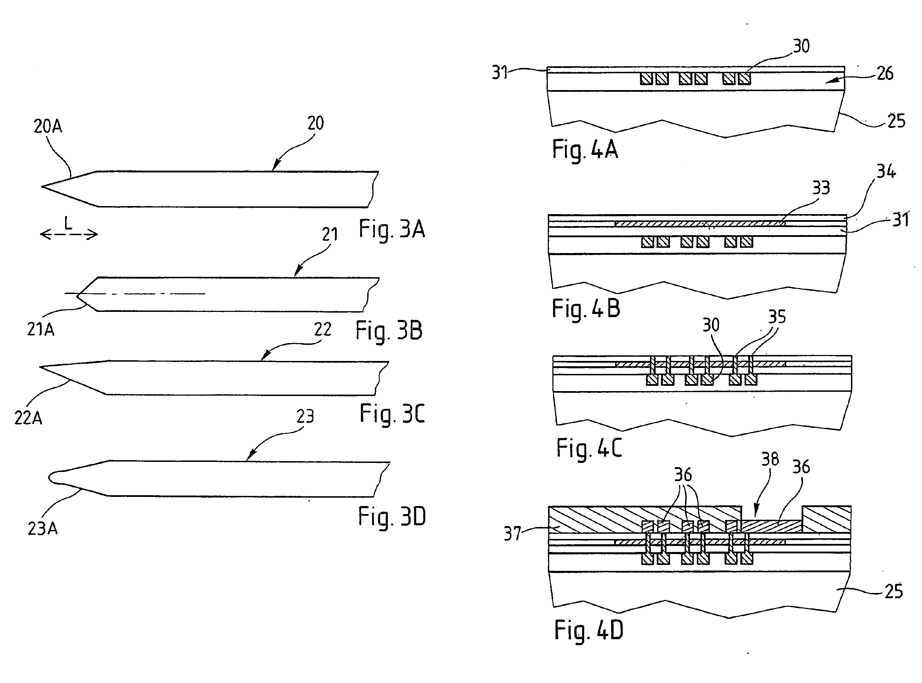

Un barreau 20 similaire à ceux représentés à la figure 2 est représenté à la figure 3A (en partie, dans la mesure où seule son extrémité gauche est représentée) ; la forme de cette extrémité notée 20A correspond à une géométrie symétrique, avec un angle très aigu (inférieur à 45° ; cet angle est même inférieur à 30° sur la figure 2), la longueur L de cette extrémité effilée étant substantiellement supérieure à la largeur du barreau.

Mais bien d'autres formes d'extrémités en pointe sont possibles.

C'est ainsi que la figure 3B représente un barreau 21 ayant une extrémité effilée 21A dont la pointe est plus courte que la largeur du barreau, l'extrémité de cette pointe étant en outre légèrement décalée vers le bas par rapport à l'axe médian de ce barreau. En effet, cette pointe n'est pas symétrique.

La figure 3C représente un autre barreau 22 ayant une autre pointe allongée 22A, comme sur la figure 3A, mais dont la dissymétrie est telle que la pointe est pratiquement dans le prolongement du côté supérieur du barreau.

Enfin la figure 3D représente un autre barreau 23 ayant une extrémité effilée 23A dont les flancs ne sont pas rectilignes, commençant par converger avant de se raccorder à une "pointe" émoussée, élargie.

Sur la figure 2, chacun des barreaux a des extrémités symétriques l'une de l'autre. Il doit toutefois bien être compris qu'un même barreau peut avoir deux extrémités de géométries différentes. De manière avantageuse, mais non nécessaire, les deux barreaux sont symétriques l'un de l'autre vis-à-vis d'une ligne les séparant, et lorsqu'ils ont des extrémités non symétriques, comme dans les cas des figures 3B et 3C, il peut se révéler préférable de rapprocher, ou au contraire éloigner, les pointes (aiguës ou arrondies) de ces extrémités.

Dans une version particulièrement simple, il n'y a qu'un seul barreau (11, ou 12) ; il est alors avantageux de choisir une configuration dans laquelle les extrémités sont symétriques par rapport à une ligne médiane de ce barreau, comme par exemple celle des figures 3A ou 3D.

De manière tout à fait surprenante il a été constaté que le composant de la figure 2, avec des barreaux dont les extrémités sont effilées, avait des résultats meilleurs que plusieurs autres configurations imaginées, pourtant plus habituelles. Avec un circuit ouvert, on pouvait s'attendre à une consommation de courant plus importante qu'avec un circuit fermé. Par ailleurs l'effilement des extrémités des barreaux pouvait paraître ne rien pouvoir apporter. Pourtant il est apparu qu'il conduisait à une moindre consommation de courant que les autres solutions standards, tout en présentant bien moins d'instabilités. Il présente en outre un rapport signal/bruit du même ordre de grandeur que les autres configurations connues.

Il est à noter que les quelques exemples de capteurs trouvés dans la littérature (voir ci-dessus) et qui ont proposé des circuits ouverts ont tous proposé des barreaux parallélépipédiques.

Il peut être noté ici, de manière très générale dans les phénomènes magnétiques, que les pointes sont souvent considérées comme ayant des effets de configuration de domaines magnétiques. Le problème est qu'il est difficile de contrôler la configuration des domaines magnétiques.

" Les figures 4A à 4D représentent à titre d'exemple des étapes de fabrication d'un capteur conforme à l'invention.

Il s'agit d'étapes à peine modifiées par rapport à celles qui peuvent être utilisées pour certains capteurs miniatures déjà réalisés en microtechnologie, mais avec des circuits magnétiques fermés ou des circuits magnétiques ouverts avec des extrémités à angle droit.

Selon la figure 4A, on part d'un substrat 25, par exemple en silicium (mais il peut s'agir en variante de verre, quartz, céramique, ...), sur lequel on va réaliser une couche 26 en matériau électriquement isolant (par exemple en Si02) formant une sorte de "caisson de bobinage" ; on dépose ensuite par électrolyse des pistes 30 d'un matériau conducteur, tel que le cuivre, l'aluminium, l'or, le tungstène, AuTa,... puis on procède à une planarisation de ce matériau. On dépose enfin une couche d'isolant 31 (typiquement du Si02, avec une épaisseur de 4 microns par exemple), avant de lui appliquer un traitement de planarisation (par exemple jusqu'à moins de 1 micron).

Puis on procède (figure 4B) à un dépôt de matériau magnétique 33 (par exemple du FeNi, ou un matériau amorphe, sur une épaisseur de l'ordre du micron). On effectue ensuite une gravure de ce dépôt magnétique pour bien en définir la géométrie, puis on le recouvre d'une nouvelle couche d'isolant 34, typiquement en Si02 que l'on planarise jusqu'à une épaisseur (par exemple de l'ordre du micron). La couche localisée de matériau magnétique est ainsi localisée sur une couche isolante 31, sous une autre couche isolante 34, et entourée d'isolant (en pratique celui déposé lors de son recouvrement par la couche 34).

A la figure 4C, on procède aux opérations de réalisation des raccords 35 aux brins inférieurs, en sorte de commencer à former les futures spires. La réalisation de ces raccords peut se faire par gravure localisée en sorte de creuser des tranchées jusqu'aux brins 30 puis dépôt d'un matériau conducteur dans ces tranchées.

A la figure 4D, on procède à un dépôt 36 d'un matériau conducteur d'épaisseur supérieure aux épaisseurs considérées précédemment, typiquement supérieure à 1,5 micron. On effectue ensuite à une gravure en sorte de délimiter dans cette couche conductrice des conducteurs supérieurs, formant ainsi des spires conjointement avec les brins 30 et les raccords 35. On procède ensuite à un dépôt isolant 37, par exemple en Si02, puis on réalise des ouvertures 38 pour permettre des contacts avec l'extérieur.

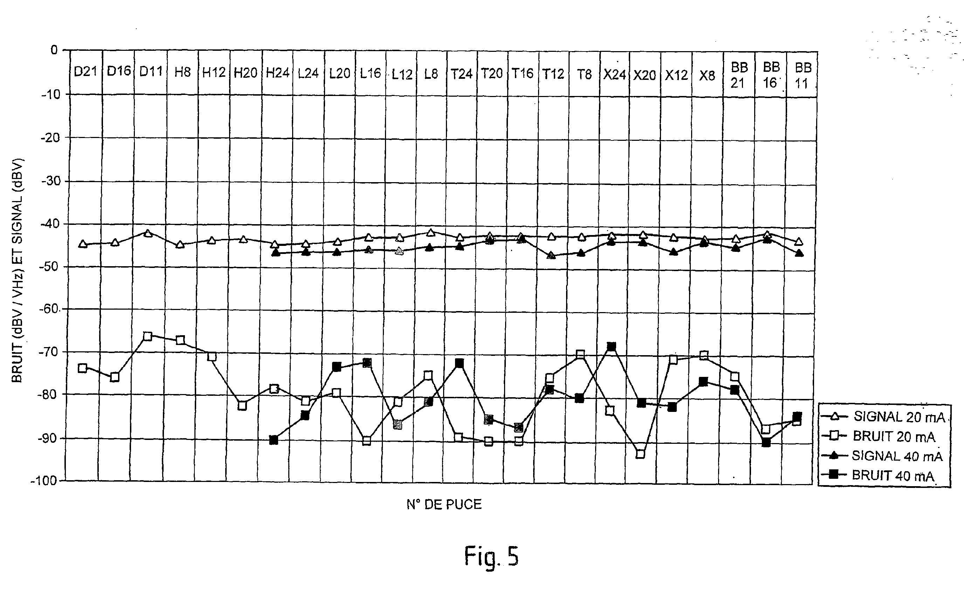

A des fins de test, une pluralité de puces a été réalisée selon la géométrie précitée, en vue d'en évaluer les performances, pour deux niveaux d'intensité (20 mA et 40 mA). La figure 5 recense pour ces diverses puces les mesures qui y ont été faites (les numéros désignant ces puces sont arbitraires).

On peut noter sur cette figure que le signal vaut en moyenne -41 dB pour 20 mA. Ce courant de 20 mA semble être un courant optimum.

Ces puces présentent des spectres parfaitement plats, sans instabilités, dans les basses fréquences, visibles sur le spectre (depuis quelques dixièmes de Hertz à 50 Hz; gamme où apparaissent fréquemment des instabilités avec les autres configurations connues). Il est par ailleurs apparu que la configuration de l'invention permet une plus grande stabilité, pour une moindre consommation de courant, mais en ayant en outre un rapport signal-bruit du même ordre de grandeur, sinon meilleur, que ces autres configurations.

## Revendications

1. Capteur miniature de champ magnétique (10) comportant un noyau magnétique (11, 12, 20, 21, 22, 23) coopérant avec au moins un bobinage d'excitation et un bobinage de détection, caractérisé en ce noyau est ouvert et comporte au moins un barreau ayant des extrémités effilées (20A, 21 A, 22A, 23A).

2. Capteur selon la revendication 1, **caractérisé en ce que** le noyau comporte au moins un second barreau (11, 12) ayant des extrémités effilées.

3. Capteur selon la revendication 2, **caractérisé en ce que** le noyau est formé de deux barreaux symétriques l'un de l'autre vis-à-vis d'une ligne les séparant.

4. Capteur selon l'une quelconque des revendications 1 à 3, **caractérisé en ce que** les extrémités d'au moins ce barreau (11, 12) sont symétriques l'une de l'autre.

5. Capteur selon l'une quelconque des revendications 1 à 4, **caractérisé en ce que** l'une au moins des extrémités de ce barreau (11, 12, 20, 23) est symétrique par rapport à une ligne médiane longitudinale de ce barreau.

6. Capteur selon l'une quelconque des revendications 1 à 4, **caractérisé en ce que** l'une au moins des extrémités de ce barreau (21, 22) est dissymétrique par rapport à une ligne médiane longitudinale de ce barreau.

7. Capteur selon l'une quelconque des revendications 1 à 6, **caractérisé en ce que** l'une au moins des extrémités (20A, 21A, 22A) est délimitée par des bords rectilignes qui convergent l'un vers l'autre.

8. Capteur selon l'une quelconque des revendications 1 à 7, **caractérisé en ce que** l'une au moins des extrémités (20A, 21 A, 22A) se termine par une pointe aiguë.

9. Capteur selon la revendication 8, **caractérisé en ce que** cette pointe forme un angle inférieur à 45°.

10. Capteur selon l'une quelconque des revendications 1 à 7, **caractérisé en ce que** l'une au moins des extrémités (23A) se termine par une pointe arrondie.

11. Capteur selon l'une quelconque des revendications 1 à 10, **caractérisé en ce que** l'une au moins des extrémités a une longueur supérieure à la largeur du barreau.

12. Capteur selon l'une quelconque des revendications 1 à 11, **caractérisé en ce que** les extrémités sont situées en dehors des bobinages d'excitation et de détection.

13. Capteur selon l'une quelconque des revendications 1 à 11, **caractérisé en ce que** les extrémités sont au moins en partie à l'intérieur d'un bobinage.

14. Capteur selon la revendication 13, **caractérisé en ce que** ce bobinage est un bobinage d'excitation.

15. Capteur selon l'une quelconque des revendications 1 à 14, **caractérisé en ce qu'**il comporte deux bobinages d'excitation disposés de part et d'autre d'un bobinage de détection.

16. Capteur selon l'une quelconque des revendications 1 à 15, **caractérisé en ce qu'**il est formé d'un empilement de couches (26, 30, 31, 35, 33, 34, 36, 37).

## Patentansprüche

1. Miniaturmagnetfeldsensor (10), der einen Magnetkern (11, 12, 20, 21, 22, 23) aufweist, der mit mindestens einer Erregerwicklung und einer Erfassungswicklung zusammenwirkt, **dadurch gekennzeichnet, dass** dieser Kern offen ist und mindestens einen Stab mit spitz zulaufenden Enden (20A, 21A, 22A, 23A) aufweist.

2. Sensor nach Anspruch 1, **dadurch gekennzeichnet, dass** der Kern mindestens einen zweiten Stab (11, 12) mit spitz zulaufenden Enden aufweist.

3. Sensor nach Anspruch 2, **dadurch gekennzeichnet, dass** der Kern aus zwei zueinander gegenüber einer sie trennenden Linie symmetrischen Stäben geformt ist.

4. Sensor nach einem der Ansprüche 1 bis 3, **dadurch gekennzeichnet, dass** die Enden mindestens dieses Stabs (11, 12) zueinander symmetrisch sind.

5. Sensor nach einem der Ansprüche 1 bis 4, **dadurch gekennzeichnet, dass** mindestens eines der Enden dieses Stabs (11, 12, 20, 23) bezüglich einer Längsmittellinie dieses Stabs symmetrisch ist.

6. Sensor nach einem der Ansprüche 1 bis 4, **dadurch gekennzeichnet, dass** mindestens eines der Enden dieses Stabs (21, 22) bezüglich einer Längsmittellinie dieses Stabs unsymmetrisch ist.

7. Sensor nach einem der Ansprüche 1 bis 6, **dadurch gekennzeichnet, dass** mindestens eines der Enden (20A, 21A, 22A) von geradlinigen Rändern begrenzt wird, die zueinander konvergieren.

8. Sensor nach einem der Ansprüche 1 bis 7, **dadurch gekennzeichnet, dass** mindestens eines der Enden (20A, 21A, 22A) in einer scharfen Spitze endet.

9. Sensor nach Anspruch 8, **dadurch gekennzeichnet, dass** diese Spitze einen Winkel von weniger als 45° formt.

10. Sensor nach einem der Ansprüche 1 bis 7, **dadurch gekennzeichnet, dass** mindestens eines der Enden (23A) in einer abgerundeten Spitze endet.

11. Sensor nach einem der Ansprüche 1 bis 10, **dadurch gekennzeichnet, dass** mindestens eines der Enden eine größere Länge als die Breite des Stabs hat.

12. Sensor nach einem der Ansprüche 1 bis 11, **dadurch gekennzeichnet, dass** die Enden sich außerhalb der Erreger- und Erfassungswicklungen befinden.

13. Sensor nach einem der Ansprüche 1 bis 11, **dadurch gekennzeichnet, dass** die Enden sich zumindest zum Teil im Inneren einer Wicklung befinden.

14. Sensor nach Anspruch 13, **dadurch gekennzeichnet, dass** diese Wicklung eine Erregerwicklung ist.

15. Sensor nach einem der Ansprüche 1 bis 14, **dadurch gekennzeichnet, dass** er zwei Erregerwicklungen aufweist, die zu beiden Seiten einer Erfassungswicklung angeordnet sind.

16. Sensor nach einem der Ansprüche 1 bis 15, **dadurch gekennzeichnet, dass** er aus einer Stapelung von Schichten (26, 30, 31, 35, 33, 34, 36, 37) geformt wird.

## Claims

1. Miniature magnetic field sensor (10) comprising a magnetic core (11, 12, 20, 21, 22, 23) cooperating with at least one excitation coil and one detection coil, **characterized in that** this core is open and includes at least one bar having tapered ends (20A, 21A, 22A, 23A).

2. Sensor according to Claim 1, **characterized in that** the core includes at least one second bar (11, 12) having tapered ends.

3. Sensor according to Claim 2, **characterized in that** the core is formed of two bars symmetrical to each other with respect to a line separating them.

4. Sensor according to any one of Claims 1 to 3, **characterized in that** the ends of at least this bar (11, 12) are symmetrical to each other.

5. Sensor according to any one of Claims 1 to 4, **characterized in that** at least one of the ends of this bar (11, 12, 20, 23) is symmetrical with respect to a longitudinal median line of this bar.

6. Sensor according to any one of Claims 1 to 4, **characterized in that** at least one of the ends of this bar (21, 22) is dissymmetrical with respect to a longitudinal median line of this bar.

7. Sensor according to any one of Claims 1 to 6, **characterized in that** at least one of the ends (20A, 21A, 22A) is delimited by rectilinear edges that converge toward each other.

8. Sensor according to any one of Claims 1 to 7, **characterized in that** at least one of the ends (20A, 21A, 22A) terminates in a sharp point.

9. Sensor according to Claim 8, **characterized in that** this point forms an angle less than 45°.

10. Sensor according to any one of Claims 1 to 7, **characterized in that** at least one of the ends (23A) terminates in a rounded point.

11. Sensor according to any one of Claims 1 to 10, **characterized in that** at least one of the ends has a length greater than the width of the bar.

12. Sensor according to any one of Claims 1 to 11, **characterized in that** the ends are situated outside the excitation and detection coils.

13. Sensor according to any one of Claims 1 to 11, **characterized in that** the ends are at least in part inside a coil.

14. Sensor according to Claim 13, **characterized in that** this coil is an excitation coil.

15. Sensor according to any one of Claims 1 to 14, **characterized in that** it comprises two excitation coils disposed one on each side of a detection coil.

16. Sensor according to any one of Claims 1 to 15, **characterized in that** it is formed of a stack of layers (26, 30, 31, 35, 33, 34, 36, 37).
